# EUROPEAN PATENT APPLICATION

(11) **EP 1 662 589 A2**
(43) Date of publication of application: **31.05.2006**
(21) Application number: 05025127.1
(22) Date of filing: 17.11.2005
(51) Int. Cl.: H01L 51/44

(54) **Organic electroluminescent device having a polarizer**

(30) Priority: 30.11.2004 KR 2004099065; 30.11.2004 KR 2004099067; 30.11.2004 KR 2004099070; 30.11.2004 KR 2004099071
(71) Applicant: LG ELECTRONICS INC., Seoul, 150-010 (KR)
(72) Inventor: Bae, Hyo Dae, Dalseo-gu Daegu 704-130 (KR); Yoon, Myung Hee, 352-2, Dangri-dong Saha-gu Busan 604-831 (KR)
(74) Representative: Zech, Stefan Markus

(57) **Abstract**

The present invention relates to an organic electroluminescent device having a circular polarizer. The organic electroluminescent device according to one embodiment of the present invention includes a substrate (10), an anode electrode layer (40), an organic layer (100), a cathode electrode layer (120), an insulation film (60) and a circular polarizer (200). The insulation film is formed on the anode electrode layer and contains a black substance. The circular polarizer is adhered to the surface of the substrate opposite to the upper side of the substrate on which the anode electrode layer is formed and polarizes a light incident from outside, wherein the polarizer contains a dye-based substance or a mixed substance of dye-based substance and iodine-based substance. Therefore, the organic electroluminescent device may improve contrast and decrease power consumption.

## Description

### CROSS-REFERENCE TO RELATED APPLICATIONS

This application claims priority from Korean Patent Applications Nos. 2004-99065, 2004-99067, 2004-99070 and 2004-99071 filed on November 30, 2004, the contents of which are incorporated herein by reference in their entirety.

### BACKGROUND OF THE INVENTION

### 1. Field of the Invention

The present invention relates to an organic electroluminescent device. In particular, the present invention relates to an organic electroluminescent device having a circular polarizer capable of decreasing power consumption.

### 2. Description of the Related Art

An organic electroluminescent device emits a light having predetermined wavelength when a certain voltage is applied thereto.

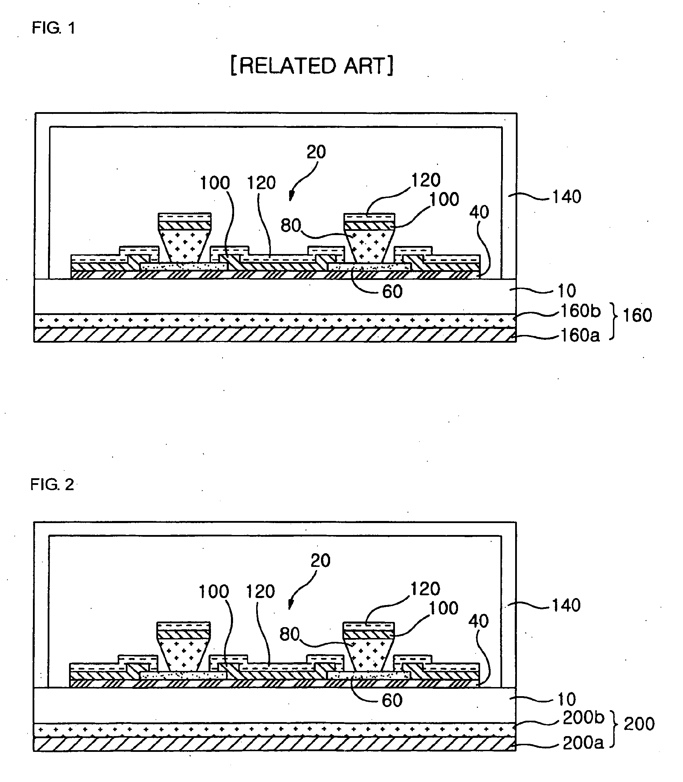

FIG 1 is a sectional view illustrating a conventional organic electroluminescent device.

In FIG 1, the organic electroluminescent device 100 includes a substrate 10, an anode electrode layer 40, an insulation film 60, a wall 80, an organic layer 100, a cathode electrode layer 120, a cell cap 140 and a circular polarizer 160.

In case a positive voltage and a negative voltage are respectively applied to the anode electrode layer 40 and the cathode electrode layer 120, a light having a certain wavelength is emitting from the organic layer 100.
The light emitting from the organic layer 100 is emitted to the outside through the circular polarizer 160.

In this case, because the circular polarizer 160 contains iodine-based substance, transmittance of the circular polarizer 160 to the light emitting from the organic layer 100, that is, transmittance of the organic electroluminescent device, is maintained at about 45%. Thus, the circular polarizer 160 has uniform transmittance to the whole area of red, green and blue wavelengths.

However, in this case, the power applied to the red and blue wavelengths is higher than the power applied to the green wavelength. That is, the power consumption of pixels for emitting the red and blue light should be higher than that of pixels for emitting the green light to maintain same brightness in each pixel.

Therefore, there has been a need to decrease the power consumption of the organic electroluminescent device.

### SUMMARY OF THE INVENTION

It is a feature of the present invention to provide an organic electroluminescent device having a polarizer to be able to improve contrast and decrease power consumption.

The organic electroluminescent device according to one embodiment of the present invention includes a substrate, an anode electrode layer, an organic layer, a cathode electrode layer, an insulation film and a circular polarizer. The insulation film is formed on the anode electrode layer and contains a black substance. The circular polarizer is adhered to the surface of the substrate opposite to the upper side of the substrate on which the anode electrode layer is formed and polarizes a light incident from the outside, wherein the polarizer contains a dye-based substance.

The organic electroluminescent device according to another embodiment of the present invention includes a substrate, an anode electrode layer, an organic layer, a cathode electrode layer, an insulation film and a circular polarizer. The insulation film is formed on the anode electrode layer and contains a black substance. The circular polarizer is adhered to the surface of the substrate opposite to the upper side of the substrate on which the anode electrode layer is formed and polarizes a light incident from the outside, wherein the polarizer contains a mixed substance of dye-based substance and iodine-based substance.

As described above, the organic electroluminescent device of the present invention may decrease power consumption by using the circular polarizer containing a dye-based substance or a mixed substance of dye-based substance and iodine-based substance.

In addition, the organic electroluminescent device of the present invention may improve contrast by using the insulation film containing a black substance.

### BRIEF DESCRIPTION OF THE DRAWINGS

The above and other features and advantages of the present invention will become readily apparent by reference to the following detailed description when considered in conjunction with the accompanying drawings wherein:
FIG. 1 is a sectional view illustrating a conventional organic electroluminescent device;
FIG. 2 is a sectional view illustrating the organic electroluminescent device according to one embodiment of the present invention;
FIG. 3 is a view illustrating transmittance of the organic electroluminescent device of FIG. 2.
FIG. 4A and FIG. 4B are views illustrating intercepting process of reflective light by using a circular polarizer according to one embodiment of the present invention.

### DESCRIPTION OF EMBODIMENTS

Hereinafter, the preferred embodiments of the present invention will be explained in more detail with reference to the accompanying drawings.

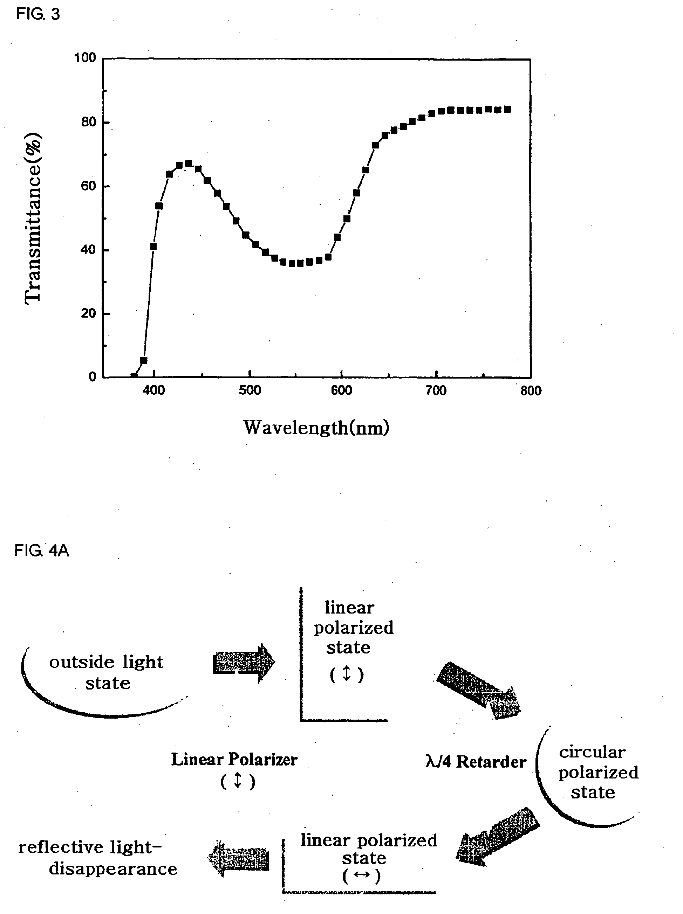

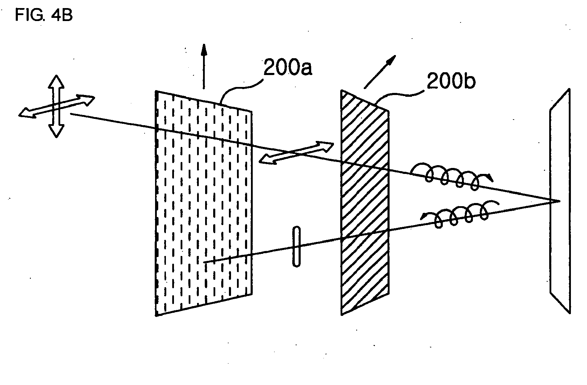

FIG. 2 is a sectional view illustrating the organic electroluminescent device according to one embodiment of the present invention, and FIG. 3 is a view illustrating transmittance of the organic electroluminescent device of FIG. 2.

In FIG 2, the organic electroluminescent device of the present invention includes a substrate 10, an anode electrode layer 40, an insulation film 60, a wall 80, an organic layer 100, a cathode electrode layer 120, a cell cap 140 and a circular polarizer 200.

The anode electrode layer 40 is deposited on the substrate 10.

The organic layer 100 is deposited on the anode electrode layer 40, and includes a hole injection layer (HIL), a hole transporting layer (HTL), an emitting layer (EML), an electron transporting layer (ETL), and an electron injection layer (EIL), in sequence.

The cathode electrode layer 120 may be formed with metal like aluminum (Al), and is deposited on the organic layer 100.

Hereinafter, a process of emitting the organic electroluminescent device will be described in detail.

The anode electrode layer 40 provides holes to the HIL in case a certain positive voltage is applied thereto. The cathode electrode layer 120 provides electrons to the EIL in case a certain negative voltage is applied thereto.

The HIL smoothly injects the holes provided from the anode electrode layer 40 to the HTL, and the EIL smoothly injects the electrons provided from the cathode electrode layer 120 to the ETL.

The HTL transports the holes injected from the HIL into the EML, and the ETL transports the electrons injected from the EIL into the EML.

The transported holes and electrons are recombined in the EML, and so a light having a predetermined wavelength is emitted from the EML.

The light emitted from the EML is emitted to the outside through the substrate 10 and the circular polarizer 200.

The circular polarizer 200 is formed on the surface of the substrate 10 opposite to the upper side of the substrate 10 on which the anode electrode layer 40 is formed, that is, the lower side of the substrate 10. And, the circular polarizer 200 transmits the light emitting from the EML with certain transmittance.

The circular polarizer 200 intercepts a light from the outside, thereby improving contrast of the organic electroluminescent device.

Hereinafter, the components of the organic electroluminescent device according to the present invention will be described.

First, the organic electroluminescent device according to a first embodiment of the present invention will be described.

The circular polarizer 200 according to the first embodiment contains a dye-based substance while the conventional polarizer 160 contains an iodine substance. In general, the dye-based substance does not well absorb the red and blue light, compared with the iodine substance. That is, the circular polarizer 200 containing the dye-based substance transmits the red and blue light better than the conventional polarizer 160 containing the iodine substance.

Thus, even in case less power is applied to the pixels emitting the red and blue light than the conventional ones, the organic electroluminescent device of the first embodiment can emit red, blue and green light with same brightness. That is, power consumption of the pixels emitting red and blue light is decreased.

The organic electroluminescent device according to the first embodiment can control transmittance of red and blue light by controlling combination of the dye-based substance. Thus, power consumption of the pixels can be controlled.

The organic electroluminescent device according to a second embodiment of the present invention will be described.

The circular polarizer 200 according to the first embodiment transmits a reflective light better than the conventional circular polarizer 160. Thus, even in case the circular polarizer 200 does not polarize the reflective light completely, the reflective light is emitted to the outside more than a conventional reflective light.

That is, by using the circular polarizer 200 containing the dye-based substance, the contrast of the organic electroluminescent device according to the first embodiment may be decreased.

Thus, the organic electroluminescent device according to the second embodiment forms the insulation film 60 as a black substance to prevent decrease of the contrast.

For example, the black substance uses a black carbon, and so on.

The insulation film 60 can be formed as black matrix layer contained a mixing substance of a black substance and at least one of organic, inorganic, and high molecular substances.

Because the insulation film 60 has black-color, in case the outside light and the reflective light reflecting from the cathode electrode layer 120 are irradiated onto the insulation film 60, those lights are absorbed. As a result, the amount of reflective light emitted to the outside after being reflected to the cathode electrode layer 120 is decreased, and the contrast of the above organic electroluminescent device is improved.

The organic electroluminescent device according to the second embodiment can decrease power consumption, with maintaining or improving the contrast.

The organic electroluminescent device according to a third embodiment of the present invention will be described.

The circular polarizer 200 according to the third embodiment contains a mixed substance of dye-based substance and iodine-based substance while the conventional polarizer 160 contains an iodine substance. In general, the dye-based substance does not well absorb red and blue light compared with the iodine substance. That is, the circular polarizer 200 containing the mixed substance transmits red and blue light better than the conventional polarizer 160 containing the iodine substance.

Thus, even in case less power is applied to the pixels emitting red and blue light than the conventional ones, the organic electroluminescent device of the third embodiment can emit red, blue and green light with same brightness. That is, power consumption of the pixels emitting red and blue light is decreased.

Also, the organic electroluminescent device according to the third embodiment can control transmittance of red and blue light by controlling combination of the mixed substance. Thus, power consumption of the pixels can be controlled.

The organic electroluminescent device according to a fourth embodiment of the present invention will be described.

The circular polarizer 200 according to the third embodiment transmits a reflective light better than the conventional circular polarizer 160. Thus, in case the circular polarizer 200 doesn' t polarize the reflective light completely, the reflective light is emitted to the outside more than a conventional reflective light.

That is, by using the circular polarizer 200 containing the mixed substance, the contrast of the organic electroluminescent device according to the third embodiment may be decreased.

Thus, the organic electroluminescent device according to the fourth embodiment forms the insulation film 60 as a black substance to prevent decrease of the contrast.

For example, black carbon, etc. are used as the black substance.

The insulation film 60 can be formed as black matrix layer contained a mixed substance of the black substance and at least one of organic, inorganic, and high molecular substances.

Because the insulation film 60 has black-color, in case the outside light and the reflective light reflecting from the cathode electrode layer 120 are irradiated onto the insulation film 60, those light are absorbed. As a result, the amount of reflective light emitted to the outside after being reflected to the cathode electrode layer 120 is decreased, and the contrast of the organic electroluminescent device is improved.

The organic electroluminescent device according to the fourth embodiment can decrease power consumption, with maintaining or improving the contrast.

Hereinafter, the circular polarizer 200 will be described in detail.

The circular polarizer 200 iricludes a retarder 200b adhered to the lower side of the substrate 10 and a linear polarizer 200a adhered to the lower side of the retarder 200b.

The linear polarizer 200a contains the mixed substance and polarizes the reflective light. In this case, the linear polarizer 200a is formed by extending a polarizer film, and dyeing the dyed-based substance or the mixed substance onto the extended polarizer film.

The central axis of the retarder 200b makes 45° to the central axis of the linear polarizer 200a. Thus, the phase of outside light passing through the linear polarizer 200a is delayed by about X /4 (X is wavelength).

In FIG 3, transmittance of the circular polarizer 200 according to red and blue light is more than about 50% and transmittance of the circular polarizer 200 according to green light is between about 45% and 50% in the present organic electroluminescent device. The central wavelength of blue light is about 460nm, that of green light is about 520nm, and that of red light is about 620nm.

FIG. 4A and FIG. 4B are views illustrating intercepting process of reflective light by using the circular polarizer according to one embodiment of the present invention.

In FIG 4A, the outside light not polarized is incident to the linear polarizer 200a.

Here, the transmittance axis of the linear polarizer 200a is formed perpendicularly. Then, the light of perpendicular direction among the outside light transmits the linear polarizer 200a.

And, the outside light penetrating the linear polarizer 200a is incident to the retarder 200b. Then, the outside light is delayed by about λ / 4 and changed to circular polarization state because the central axis of the retarder 200b makes 45°to the central axis of the linear polarizer 200a.

Next, the outside light penetrating the retarder 200b is reflected to the cathode electrode layer 120, and the reflected light transmits the retarder 200b again.

As a result, the reflective light of circular polarization state is changed to linear polarization state. Only, the reflective light again retransmitting the retarder 200b is perpendicular to the outside light not transmitting the retarder 200b at all because the outside light is delayed by about λ / 4 whenever the outside light transmits the retarder 200b, that is, about λ / 2 since it is transmitted twice.

And, the reflective light of linear polarization state is incident to the linear polarizer 200a, and then disappeared. Because the reflective light of linear polarization state is formed perpendicularly to the transmittance axis of the linear polarizer 200a, all the reflective light of linear polarization state is polarized.

In FIG. 4B, the outside light not polarized is incident to the linear polarizer 200a.

Here, the absorption axis of the linear polarizer 200a is formed in perpendicular direction. Thus, only the light of horizontal direction among the outside light transmits the linear polarizer 200a.

And, the outside light transmitting the linear polarizer 200a transmits the retarder 200b. As a result, the outside light proceeds into the inside of the organic electroluminescent device in circular polarization state as shown in FIG. 4B.

Next, thus proceeded outside light again transmits the retarder 200b by being reflected from the cathode electrode layer 120.

And, the reflective light transmitting the retarder 200b is incident to the linear polarizer 200a, and all of them is polarized and disappeared.

The outside light is disappeared by transmitting the circular polarizer 200 twice as shown in FIG: 4A and FIG. 4B. Thus, the organic electroluminescent device of the present invention has high contrast, compared with organic electroluminescent device not having the circular polarizer 200.

From the preferred embodiments for the present invention, it is noted that modifications and variations can be made by a person skilled in the art in light of the above teachings. Therefore, it should be understood that changes may be made for a particular embodiment of the present invention within the scope and the spirit of the present invention outlined by the appended claims.

## Claims

1. An organic electroluminescent device in which an anode electrode layer, an organic layer and a cathode electrode layer are formed in sequence on a substrate, comprising:
a circular polarizer adhered to the surface of the substrate opposite to the upper side of the substrate on which the anode electrode layer is formed, wherein the polarizer polarizes a light incident from outside and contains a dye-based substance.

2. The organic electroluminescent device of claim 1, further including an insulation film formed on the anode electrode layer, wherein the film contains a black-substance.

3. The organic electroluminescent device of claim 1 or 2, wherein the circular polarizer includes:
a retarder adhered to the surface of the substrate opposite to the upper side of the substrate on which the anode electrode layer is formed, for delaying an incident light; and
a linear polarizer adhered to the surface of the retarder opposite to the upper side of the substrate, and containing the dye-based substance.

4. The organic electroluminescent device of claim 1, 2 or 3, wherein the circular polarizer optionally better transmits a light of predetermined wavelength among the light generated from the organic layer.

5. The organic electroluminescent device of claim 4, wherein the circular polarizer transmits red light and blue light with transmittance of more than about 50% and green light with transmittance of between about 45% and 50% among the light generated from the organic layer.

6. An organic electroluminescent device in which an anode electrode layer, an organic layer and a cathode electrode layer are formed in sequence on a substrate, comprising:
a circular polarizer adhered to the surface of the substrate opposite to the upper side of the substrate on which the anode electrode layer is formed, wherein the polarizer polarizes a light incident from outside and contains a mixed substance of dye-based substance and iodine-based substance.

7. The organic electroluminescent device of claim 6, further including an insulation film formed on the anode electrode layer, wherein the film contains a black-substance.

8. The organic electroluminescent device of claim 6 or 7, wherein the circular polarizer includes:
a retarder adhered to the surface of the substrate opposite to the upper side of the substrate on which the anode electrode layer is formed, for delaying an incident light; and
a linear polarizer adhered to the surface of the retarder opposite to the upper side of the substrate, and containing the mixed substance.

9. The organic electroluminescent device of claim 6, 7 or 8, wherein the circular polarizer optionally better transmits a light of predetermined wavelength among the light generated from the organic layer.

10. The organic electroluminescent device of claim 9, wherein the circular polarizer transmits red light and blue light with transmittance of more than about 50% and green light with transmittance of between about 45% and 50% among the light generated from the organic layer.
